# EUROPEAN PATENT APPLICATION

(11) **EP 0 889 365 A1**
(43) Date of publication of application: **07.01.1999**
(21) Application number: 97304795.4
(22) Date of filing: 01.07.1997
(51) Int. Cl.: G03F 7/20, G03F 7/24

(54) **Apparatus for exposing and developing printing plates**

(71) Applicant: Kabushiki Kaisha Kaneda Kikai Seisakusho, Toyonaka-shi, Osaka-fu (JP)
(72) Inventor: Okamura, Yuichi, K.K. Kaneda Kikai Seisakusho, Toyonaka-Shi, Osaka-Fu (JP); Hosokawa, Junichi, Abiko-Shi, Chiba-Ken (JP); Watanabe, Takemi, K.K. Kaneda Kikai Seisakusho, Toyonaka-Shi, Osaka-Fu (JP)
(74) Representative: Crump, Julian Richard John

(57) **Abstract**

The invention provides apparatus for exposing and developing printing plates, particularly printing plates for newspaper printing, which apparatus comprises a printing plate holding station (A) for holding a stock of unexposed plates (P); a plate exposing station (B1;B2) comprising an exposing device (6a,8a1,8a2;6b,8b1,8b2) for image-wise exposing said printing plates; a development station (D) for developing the exposed plates; and transport means (2,3,4;14) for transporting the plates individually from the holding means to the exposing station and from the exposing station to the development station; wherein the exposing station further comprises a plate supplying means (10a,10b) adjacent the exposing device, which supplying means is adapted to receive a printing plate from the transport means and supply it to the exposing device; characterised in that said exposing station further comprises a plate receiving means (11a,11b) adjacent the exposing device adapted to receive the plate from the exposing device for onward transport by the transport means. Preferably, the exposing device may comprise a rotatory plate carrier drum (6a;6b) and an exposing element, wherein the rotatory drum is adapted to carry the plate on its surface and move it progressively past the exposing element.

## Description

The present invention provides improvements in or relating to apparatus for exposing and developing printing plates, particularly printing plates for newspaper printing. Specifically, the present invention provides a method for exposing and developing such printing plates, and apparatus therefor.

In recent years, computer-based technology has been developed for processing images and information. So-called "CTP" (computer-to-plate) machines have been devised for directly forming images on printing plates using a laser-beam scanning head that is provided with an input image signal from a computer. Such CTP machines are widely used in the field of news printing. In this field, a constant requirement is to increase the speed and efficiency of printing; it is desirable to print more and more newspapers in ever shorter periods of time.

Once solution to this problem is to increase the size of each printing plate, for example by using plates equivalent to two pages of newspaper as compared with only one page, thereby decreasing the total number of printing plates that have to he used and concomitantly decreasing the down-time of the newspaper rotatory press for replacing the plates. Although this solution has been successful in reducing the printing plates setting time required for printing plate replacement by approximately half, the solution is not completely satisfactory, because each plate takes longer to produce, being larger. In fact, the time required for producing a printing plate is increased from approximately four minutes in the case of a "one page" plate to about five and a half minutes in the case of a "two page" plate, because the image area of the plate is increased.

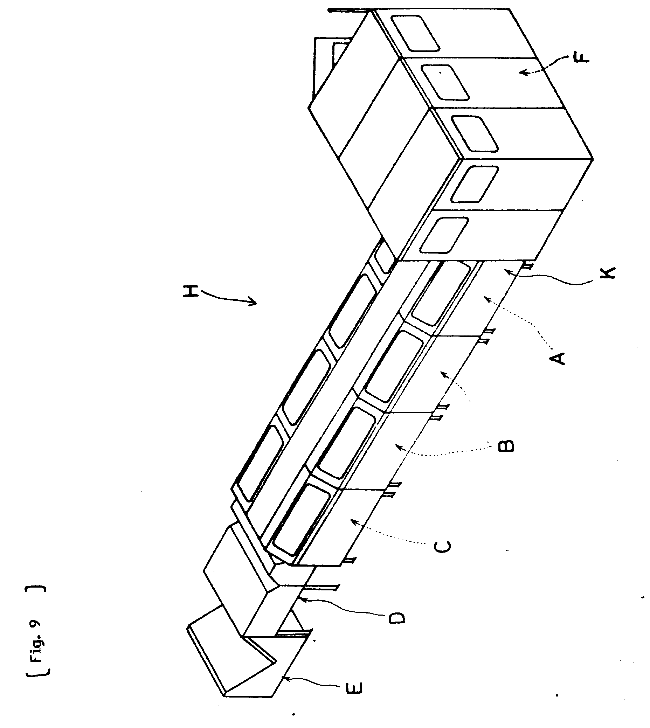

In order to derive maximum benefit from the use of enlarged printing plates therefore, the time required to produce each plate must be reduced. A solution to this problem is disclosed by the present applicants in their Japanese patent application no. 222141/1995 which discloses apparatus for exposing and developing CTP printing plates of the kind illustrated in Figures 9 to 11 of the accompanying drawings.

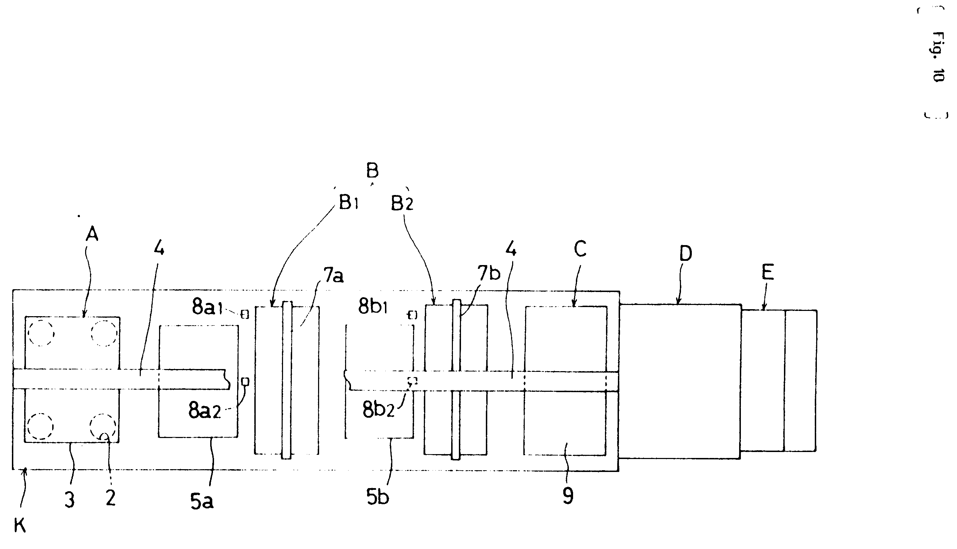

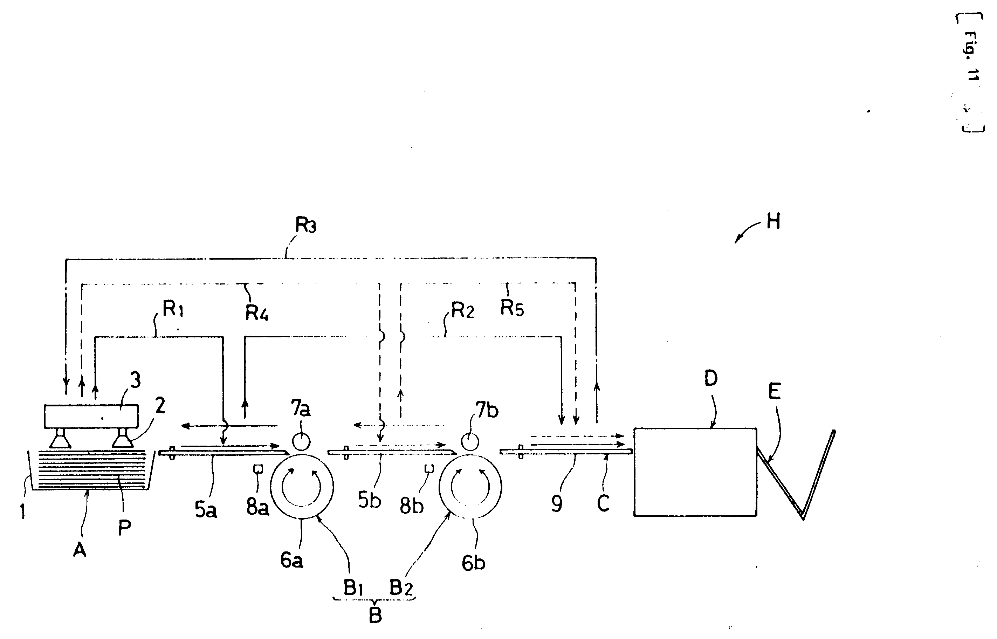

Referring to Figure 9, which is a perspective view from above and to one side, the apparatus of Japanese patent application no. 222141/1995 comprises a dark room station F, a plate feed station A, an exposure station B, a plate discharge station C, a developing station D, and a printing plate storage station E. Each of these stations is arranged on a machine direction axis within a housing K. Turning to Figures 10 and 11 which are respectively schematic plan and side views of part of the apparatus of Figure 9, it will be seen that the exposure station B comprises two plate exposing stations B1, B2. Each exposing station B1, B2 comprises a plate carrier drum 6a, 6b that is rotatable about an axis that extends across the machine direction axis adjacent a laser beam scanning head 8a, 8b.

Said plate feed station A comprises a stocker case (1) that accommodates a stack of unexposed printing plates P. Said plates are supplied packed with slip sheets interposed each neighbouring pair of plates. The packed plates P are unpacked in the dark room station F, and the slip sheets are removed from between them. The plates are then placed in the stocker case (1). Said plates P are transported one at a time from the stocker case (1) alternately to the two plate exposing stations B1, B2 by a transfer head (3) comprising a plurality of vacuum-type suckers (2); said transfer head (3) can move vertically and horizontally, and is guided by a guide rail (4). At each station, the printing plate is placed on a table 5a, 5b that is positioned up-stream of and adjacent to the respective plate carrier drum 6a, 6b. As the carrier drum rotates in one direction, the a pushing mechanism on the table 5a, 5b pushes the plate onto the surface of the drum where it is moved progressively passed the laser beam scanner head 8a, 8b by rotation of the drum. Transfer rolls 7a, 7b are provided to facilitate the transfer of the plates P between the tables 5a, 5b and the drums 6a, 6b.

Said laser beam scanner heads 8a, 8b are connected to a computer (not shown) that outputs an image signal to the scanning heads 8a, 8b, such that the plates are image-wise exposed. The plates B are provided with a surface "OPC" (organic photo conductor) layer, such that the scanning head 8a, 8b forms an electrostatic laser image on the plate. On completion of the exposing step, the carrier drum 6a, 6b is rotated in the opposite direction such that the plate is returned to the table 5a, 5b from where it is transported by the transport head (3) to a table (9) within the plate discharge station C; a pushing device fitted to table (9) is actuated to push the plates sequentially to the developing station D.

Thus it will be seen that the apparatus of Japanese patent application no. 222141/1995 is operated to transfer alternate plates from the stocker case (1) on a first path R1 to one of the plate exposing stations B1, and on path R4 to the other plate exposing station B2. The plates are then transported successively from the exposing stations B1, B2 on paths R2 and R5 to the discharge station C. The transfer head (3) is then returned to the stocker case 1 on path R3.

The time taken to transfer each plate P from the stocker case (1) to one of the exposing stations B1, B2 is about 15 seconds. It also takes about 15 seconds for the transfer head (3) to return on route R3 to the stocker case (1). It takes about 13 seconds to place a plate on one of the drum carriers 6a, 6b, and another 13 seconds to remove the plate from the drum carrier. The time taken to expose image-wise a plate on one of the drum carriers is about 153 seconds. Because the tables 5a, 5b are used to hold plates P before the plates are delivered to the carrier drums 6a, 6b, and also to hold the plates P after they are removed from the drums 6a, 6b, it is impossible to transfer succeeding plates P to the drum carriers 6a, 6b before the preceding plates are removed from the tables 5a, 5b to the discharge station C. As a result, operation of each exposing station B1, B2 is interrupted by about 45 seconds (the "waiting time") for operation of the transfer head (3). Even if the exposing time is shortened by using a plurality of laser beam scanning heads at each exposing station, it is impossible to reduce substantially the total time required for exposing each plate, because the waiting time cannot be reduced.

Accordingly, it is an object of the present invention to provide an improved method and apparatus for exposing and developing printing plates.

In particular, it is an object of the invention to provide an apparatus and method for exposing and developing printing plates in which the waiting time is reduced.

Another object of the present invention is to reduce the waiting time without substantially increasing the size or manufacturing cost of the apparatus.

According to one aspect of the present invention therefore there is provided a method of exposing and developing printing plates, particularly printing plates for use in newspaper printing, which method comprises transporting an unexposed printing plate from a stock of such unexposed plates to a plate supplying means; supplying said plate from the supplying means to an exposing means for image-wise exposing the plate; receiving the plate from the exposing means on a receiving means, and thereafter transporting the plate to a developing means for developing the image on the plate.

Thus, when one plate has been supplied to the exposing means from the supplying means, the said supplying means is then freed to take delivery of the next succeeding plate.

In a different aspect of the present invention there is provided apparatus for exposing and developing printing plates, particularly printing plates for newspaper printing, which apparatus comprises a printing plate holding station (A) for holding a stock of unexposed plates (P); a plate exposing station (B1;B2) comprising an exposing device (6a,8a1,8a2;6b,8b1,8b2) for image-wise exposing said printing plates; a development station (D) for developing the exposed plates; and transport means (2,3,4;14) for transporting the plates individually from the holding means to the exposing station and from the exposing station to the development station; wherein the exposing station further comprises a plate supplying means (10a,10b) adjacent the exposing device, which supplying means is adapted to receive a printing plate from the transport means and supply it to the exposing device; characterised in that said exposing station further comprises a plate receiving means (11a,11b) adjacent the exposing device adapted to receive the plate from the exposing device for onward transport by the transport means.

Said exposing device may comprise a rotatory plate carrier drum apparatus characterised in that said exposing device comprises a rotatory plate carrier drum (6a;6b) and an exposing element (8a1,8a2;8b1,8b2), wherein the rotatory drum is adapted to carry the plate on its surface and move it progressively passed the exposing element.

In some embodiments, said means may be arranged to one side of the carrier drum, and the receiving supporting means may be arranged to the other side of the carrier drum.

Alternatively, said supplying means and receiving means may be arranged to the same side of the carrier drum, and may be vertically spaced from one another.

Preferably, said apparatus may comprise a second such exposing station, and said transfer means may be adapted for transferring the plates alternately to the first and second exposing station.

In another aspect of the present invention there is provided a machine for exposing and developing printing plates, particularly printing plates for newspaper printing, which machine comprises two apparatus in accordance with the present invention.

Said transfer means may comprise a suction transfer head that is movable vertically and horizontally for transferring said plates from the holding means to the exposing station(s). Said suction transfer head may further be operable for transferring the plates from the exposing station(s) to the development station.

In some embodiments, said transfer means may further comprise a conveyor for conveying plates from the second supporting means to the development station.

In some embodiments, said supplying means may comprise a table that is fitted with displacing means for displacing the plate from the table to the carrier drum.

Said holding station, exposing station(s) and development station may be arranged sequentially on a machine direction axis. Said carrier drum may be rotatable about a substantially horizontal axis that extends across the machine direction axis, with the supplying means disposed upstream of the carrier drum and the receiving means disposed downstream of the carrier drum. Alternatively, the axis of rotation of the carrier drum may be arranged substantially parallel to the machine direction axis, and transfer between the supplying and receiving means may be in a direction transverse the machine direction axis.

In accordance with the apparatus and method of the present invention, it is possible to reduce substantially the waiting time as hereinbefore defined, because a receiving means that is separate from the supplying means is provided at the or each exposing station for receiving each plate after it has been image-wise exposed on the carrier drum. Where separate conveying means are provided for conveying the plates from the exposing station(s) to the development station, it is possible to operate the exposing station(s) continuously with no waiting time when the exposure time is more than about 50 seconds.

Following is a description by way of example only and with reference to the accompanying drawings of methods of carrying the present invention into effect. In the drawings:-
Figure 1 is a schematic plan view of an apparatus according to the present invention for exposing and developing a printing plate for newspaper printing.
Figure 2 is a schematic side view of the apparatus of Figure 1.
Figure 3 is a schematic plan view of another apparatus according to the present invention for exposing and developing printing plates.
Figure 4 is a schematic side view of the apparatus of Figure 3.
Figure 5 is a schematic plan view of yet another apparatus according to the present invention for making printing plates.
Figure 6 is a schematic side view of the apparatus of Figure 5.
Figure 7 is a schematic plan view of a machine for photo-engraving printing plates in accordance with the present invention.
Figure 8 comprises schematic side views of the two parts of the machine of Figure 7.

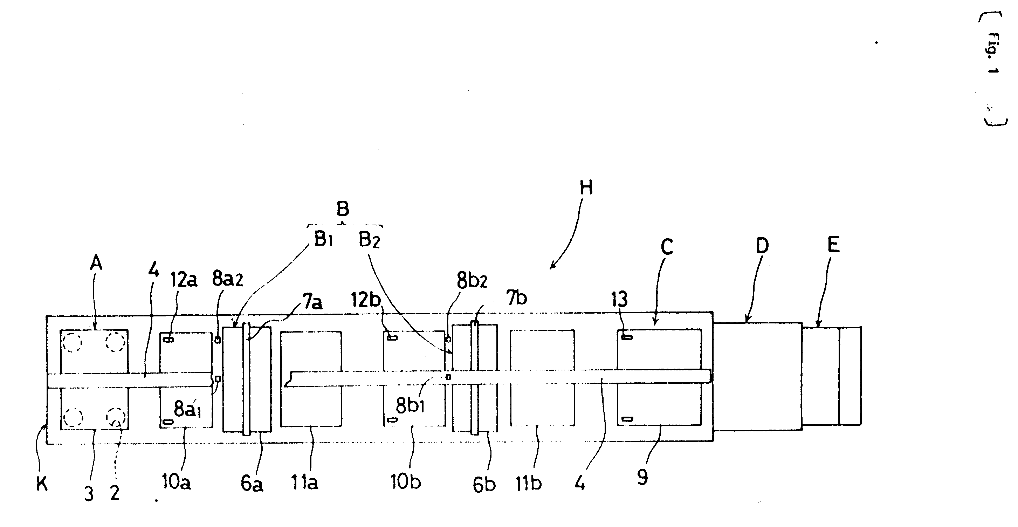

In Figures 1 to 7 of the accompanying drawings, components that are common with the apparatus of Japanese patent application no. 222141/1995 illustrated in Figures 9 to 11 are given the same reference numerals as in those Figures.

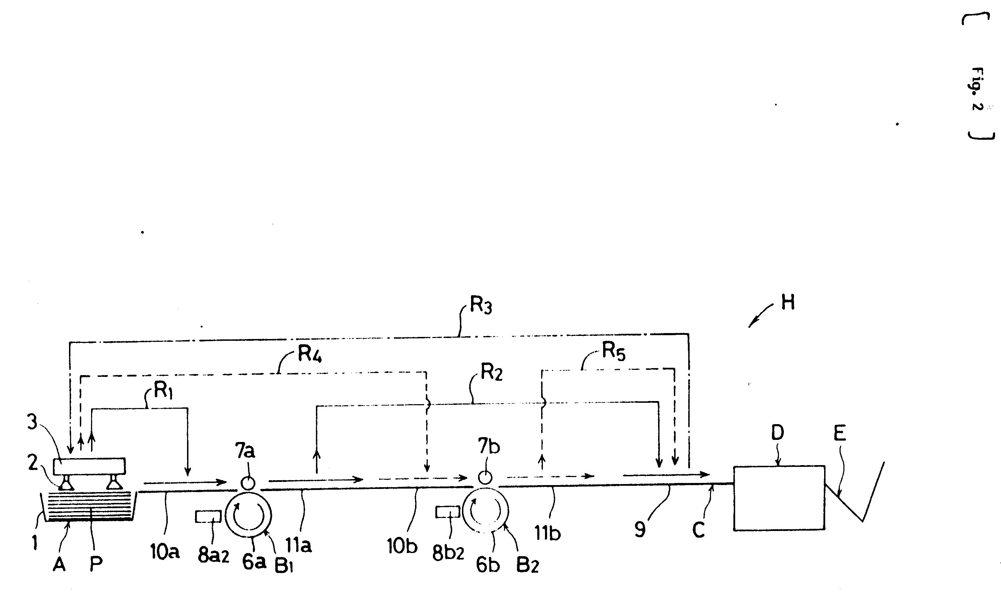

The apparatus of Figures 1 and 2 comprises a substantially light-proof housing K that accommodates a plate feed station A, two plate exposing stations B1, B2, a development station and a printing plate storing station E. The apparatus further comprises a dark room (not shown) for unpacking unexposed printing plates P to remove the interposing slip-sheets. The plate feed station, plate exposing station and development stations are situated in succession on a machine direction axis. A substantially horizontal guide rail (4) that is spaced vertically above the various stations A, B1, B2, D extends substantially parallel to the machine direction axis and carries a transfer head (3) having a plurality of suction units (2), which suction units (2) can be operated to pick-up a printing plate P. The unexposed printing plates are transferred from the dark room to a stocker case (1) in the plate feed station A, from where they are picked-up by the transfer head (3) individually and transported alternately to the two plate exposing stations B1, B2.

Each exposing station B1, B2 comprises a printing plate carrier drum 6a, 6b and an associated transfer roll 7a, 7b. Upstream of the carrier drum 6a, 6b there is disposed a table 10a, 10b onto which the printing plate is placed by the transfer head (3).

The table 10a, 10b is provided with a pusher device for pushing the plate P from the table 10a, 10b into abutment with the printing plate carrier drum 6a, 6b. In the embodiment shown, the pushing device comprises two spaced pins 12a or lugs that can be caused or allowed to slide in slots formed in the table. Alternative forms of pushing device will be readily apparent to persons skilled in the art.

The carrier drum 6a, 6b can be operated to rotate about an axis that extends across the machine direction axis of the apparatus. The pushing device can be operated to move the printing plate on the table 10a, 10b downstream such that it engages the carrier drum 6a, 6b and transfer roll 7a, 7b, so that the plate is transferred onto and wrapped around the outer, cylindrical surface of the drum 6a, 6b. Each carrier drum 6a, 6b is provided with a pin (not shown) for locating the plate P and suction means (also not shown) for holding the printing plate onto the outer surface of the drum by suction. Said transfer roll 7a, 7b is formed with a circumferential groove, so that it does not interfere with the pin on the drum carrier.

Adjacent the carrier drum 6a, 6b of each exposing station B1, B2 there is disposed one or more laser beam scanning heads 8a1, 8a2, 8b1, 8b2 that are connected to a computer (not shown): In the embodiment illustrated in Figures 1 and 2, two laser beam scanning heads are shown per carrier drum, although one, two, three or more may be used. Whilst the laser beam scanning heads of the apparatus shown in Figures 1 and 2 are disposed externally of the printing plate carrier drum 6a, 6b it is envisaged that scanning heads disposed internally of the drums may also be used.

At each exposing station, positive electric charges are applied to the OPC layer of each plate P by corona discharge prior to laser beam scanning. This technique will be well known to persons skilled in the art, and will not be described further.

In this embodiment, each of the plates P is provided with an organic photo-conductor layer. It is envisaged however that the present invention may be applied equally to plates having high-sensitivity photo-polymer layers, silver or silver halide emulsion layers, silver plus diazo-hybrid layers, or thermo-sensitive layers. Said computer outputs a digital image signal to the image scanning heads 8a1, 8a2, 8b1, 8b2, such that as the carrier drums 6a, 6b rotate, plates P on them move progressively passed the respective scanning heads 8a1, 8a2, 8b1, 8b2 so as to expose image-wise the photo sensitive layers on the plates P by forming an electrostatic latent image.

Continued rotation of the carrier drum 6a, 6b in each exposing station B1, B2 delivers the plate P thereon onto a second receiving table 11a, 11b disposed adjacent to and downstream of the carrier drum 6a, 6b. From the second table 11a, 11b, the plate is transferred by the transfer head (3) to a plate discharge station C comprising a sliding table (9) that transport each plate in turn to the development station D.

Thus, in this embodiment of the invention, successive plates P are transferred from the stocker case (1) alternately to the two exposing stations B1, B2 along paths R1 and R4 respectively. After exposure, the transfer head (3) transports the plates from the second table 11a, 11b of the two exposing stations to the plate discharge station C on paths R2 and R5 respectively. The transfer head (3) is then returned to the datum position at the stocker case (1) on path R3. At each exposing station, once a printing plate has been transferred from the first table 10a, 10b onto the printing plate carrier drum 6a, 6b, the first table 10a, 10b is freed to receive the next succeeding printing plate P.

In the development station D, positively charged toner particles are attached to the electrostatic latent image on the plates P by the so-called "reversal development method", such that the electrostatic latent images developed. The developed toner particles are thereafter heated by a halogen lamp or the like and fixed. The development and fixed plates are then sent to an elution station (not shown) where each plate is given a printing surface by removing the OPC layer other than the fixed toner image portion by means of an alkaline solution and finally, the plate surface is subjected to a protective treatment in which mucilage is applied to the surface of the plate.

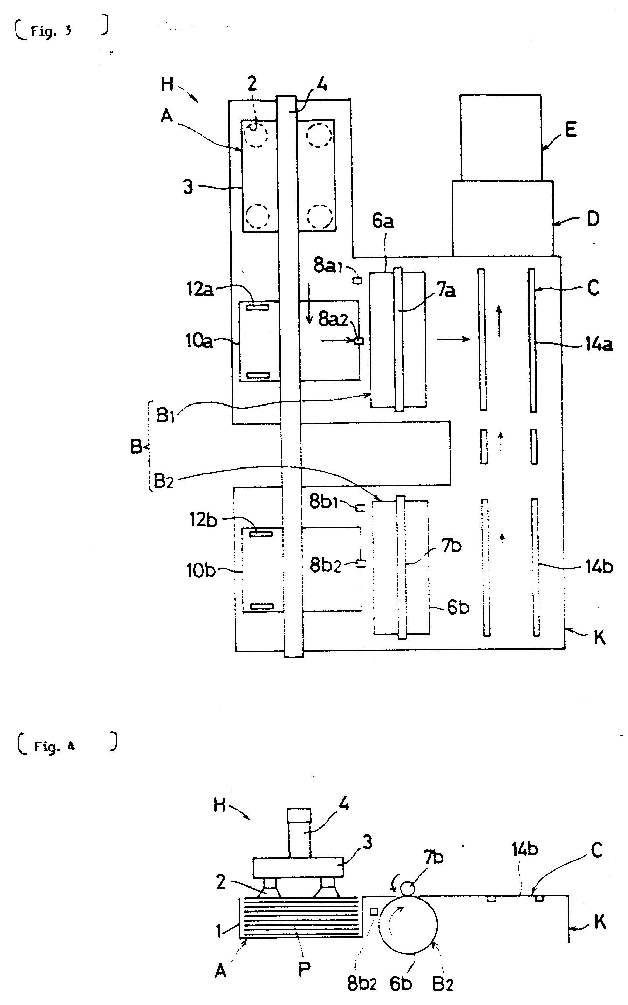

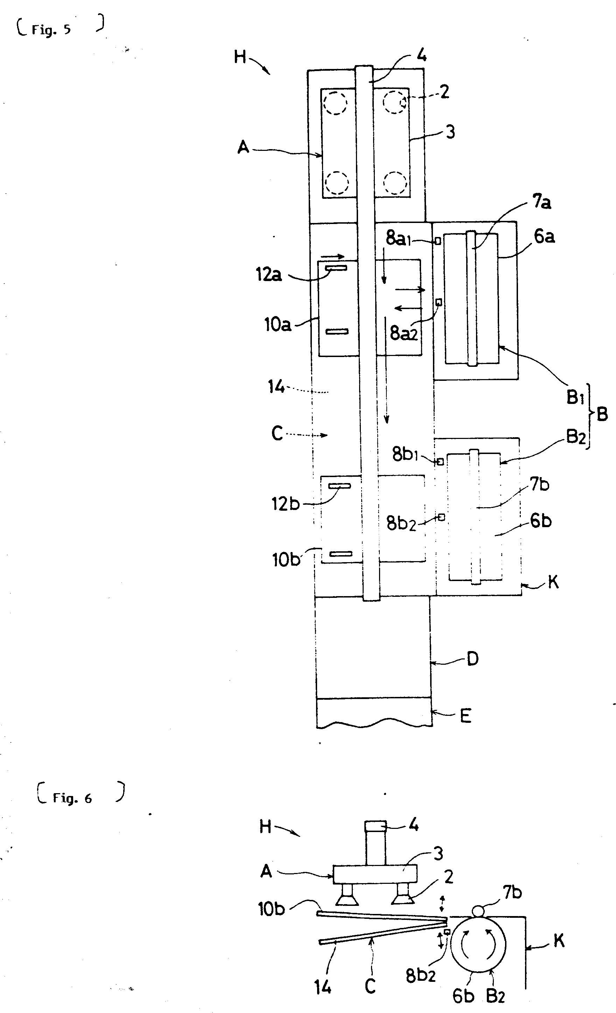

Turning now to Figures 3 and 4, the apparatus illustrated in these figures differs from the apparatus shown in Figures 1 and 2 in that the various stations A, B1, B2, C, D, E are not situated along a linear machine direction axis. A linear guide rail (4) is used to transport the printing plates P from the stocker case (1) along a first axis to the two exposing stations B1, B2 alternately. At each exposing station B1, B2, the carrier drums 6a, 6b are offset from the first axis and are arranged for rotation about substantially horizontal axes that are oriented substantially parallel to the first axis. The printing plates are thus transferred to the first tables 10a, 10b which are located on the first axis and are then fed onto the respective carrier drums 6a, 6b in a direction across the first axis. After exposure, the plates are delivered onto an elongate, supporting surface that incorporates conveyors 14a, 14b that are associated with respective exposing stations B1, B2. The conveyors 14a, 14b can be operated to transport the image-wise exposed printing plates P to the development station D. In this embodiment, the transfer head (3) thus takes no part in transferring the printing plates downstream of the exposing stations B1, B2. Provided the residence time of each plate P in an exposing station is about 50 seconds or more, the apparatus can be operated continuously with no "waiting time" of the exposing drums.

The apparatus of Figures 5 and 6, like that of Figures 1 and 2, has the various stations A, B, C, D, E situated on a single machine direction axis. The apparatus of Figures 5 and 6 differs from that of Figures 1 and 2 however in that, like the apparatus of Figures 3 and 4, the printing plate carrier drums 6a, 6b are off-set from the machine direction axis with their axes of rotation oriented substantially parallel to the machine direction axis. The printing plates P are transferred alternately from the stocker case (1) of the plate feed station A to the first tables 10a, 10b of the two exposing stations B1, B2. The first table 10a, 10b can be operated to feed the plate P onto the carrier drum 6a, 6b where it is image-wise exposed by laser beam scanning heads 8a1, 8a2, 8b1, 8b2 in the manner hereinbefore described. After exposure, the carrier drum 6a, 6b rotates in the opposite direction to transfer the plate from the drum onto a second supporting surface (14) that is vertically spaced above or below the first table 10a, 10b: in the drawings, the second supporting surface (14) is shown below the first table 10a, 10b. As with the apparatus of Figures 3 and 4, the second supporting surface incorporates a conveyor that conveys the exposed plates P to the development station D. The apparatus of Figures 5 and 6 represents a compact, space-saving design.

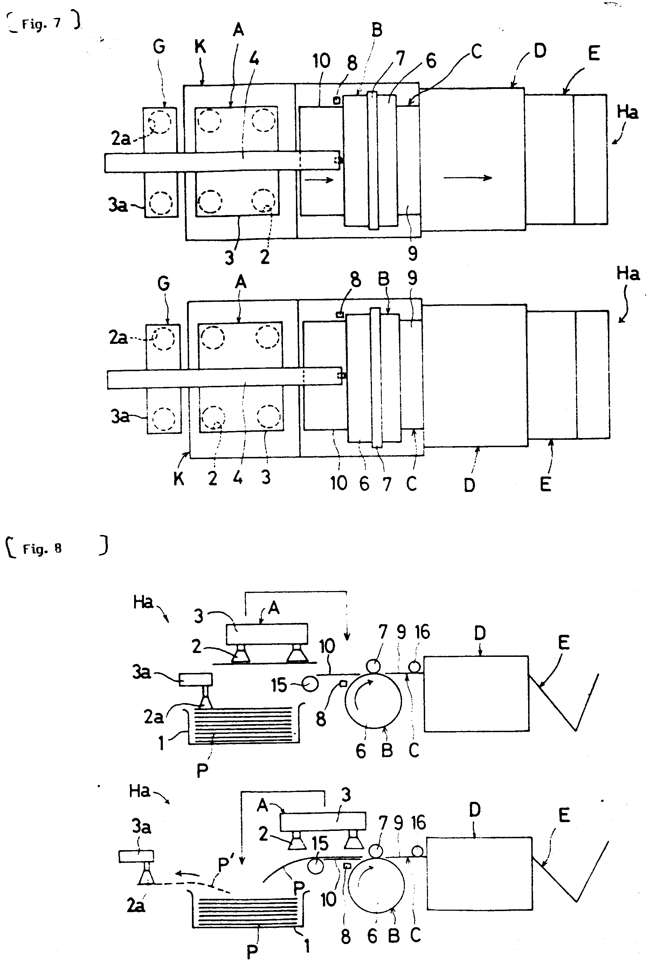

Referring now to Figures 7 and 8, the machine illustrated therein comprises two identical plate developing and exposing units Ha, each unit comprising a plate feed station A, development station B, discharge station C, development station D and plate storage station E of the kind described above. Each unit Ha however comprises only one exposing station within the exposure part of the unit. As before, the exposing station B of each unit comprises a rotatable plate carrier drum (6). A first table (10) is disposed up-stream of the drum (6) for receiving plates sequentially from the stocker case (1) and a second table (9) is located adjacent the drum and stream thereof for receiving plates from the drum. As before, this enables the unit to be operated substantially continuously, without a drum standing idle as in the prior Japanese patent application no. 222141/1995.

Figures 7 and 8 also illustrate a slip sheet removing device G that is accommodated in the plate feed station A of each unit Ha. Said slip sheet removing device G comprises a movable head (3a) having a plurality, in this case two of of suction elements (2a). The use of the slip sheet removing device G avoids the need for the printing plates P to be unpacked in a dark room as hereinbefore described. As each printing plate P is removed from the stocker case (1) by the transfer head (3), the slip sheet removing device G can be operated to remove the slip sheet interposing the next plate in the stack before it is picked up by the transfer head.

The two units Ha of the machine of Figures 7 and 8 can be operated independently with a high level of efficiency, and moveover the maintainability and light-interrupting characteristics of the machine are greatly improved, thus completely off-setting the increased manufacturing cost of the machine.

## Claims

1. Apparatus for exposing and developing printing plates, particularly printing plates for newspaper printing, which apparatus comprises a printing plate holding station (A) for holding a stock of unexposed plates (P); a plate exposing station (B1;B2) comprising an exposing device (6a,8a1,8a2;6b,8b1,8b2) for image-wise exposing said printing plates; a development station (D) for developing the exposed plates; and transport means (2,3,4;14) for transporting the plates individually from the holding means to the exposing station and from the exposing station to the development station; wherein the exposing station further comprises a plate supplying means (10a,10b) adjacent the exposing device, which supplying means is adapted to receive a printing plate from the transport means and supply it to the exposing device; characterised in that said exposing station further comprises a plate receiving means (11a,11b) adjacent the exposing device adapted to receive the plate from the exposing device for onward transport by the transport means.

2. Apparatus as claimed in claim 1, characterised in that said exposing device comprises a rotatory plate carrier drum (6a;6b) and an exposing element (8a1,8a2;8b1,8b2), wherein the rotatory drum is adapted to carry the plate on its surface and move it progressively passed the exposing element.

3. Apparatus as claimed in claim 1 or claim 2, wherein the plate supplying means is disposed to one side of the exposing device, and the receiving means is disposed to the other side.

4. Apparatus as claimed in claim 1 or claim 2, wherein the plate supplying means and plate receiving means are disposed to the same side of the drum and are vertically spaced from one another.

5. Apparatus as claimed in any of claims 1 to 4, wherein further comprising a second such exposing station, and said transport means is adapted to transport said plates alternately from the holding station to the first and second exposing stations.

6. Apparatus as claimed in any preceding claim, wherein said transport means comprises a suction transfer head (3) that is movable for moving the plates (P) between the holding station and the exposing station(s) (B1,B2).

7. Apparatus as claimed in claim 6, wherein said transfer head (3) is also movable for transporting the plates from the exposing station(s) to the development station.

8. Apparatus as claimed in any preceding claim, wherein said transport means further comprises a conveyor (14) for conveying the plates from the exposing station(s) to the development station.

9. Apparatus as claimed in any preceding claim, wherein said plate supplying means comprises a table (10a;10b) that is adapted to receive the plate from the transport means and displacing means (13a;13b) for displacing the plate from the table to the exposing device.

10. Apparatus as claimed in any preceding claim wherein the holding station, exposing stations and development station are arranged sequentially on an axis.

11. Apparatus as claimed in claim 10 wherein the plate supplying means and plate receiving means are spaced from one another along the said axis.

12. Apparatus as claimed in claim 10 wherein the plate supplying means and plate receiving means are spaced from one another across the axis.

13. A machine for making printing plates (P), which machine comprises two apparatus as claimed in any preceding claim.

14. A method of exposing and developing printing plates, particularly printing plates for use in newspaper printing, which method comprises transporting an unexposed printing plate from a stock of such unexposed plates to a plate supplying means; supplying said plate from the supplying means to an exposing means for image-wise exposing the plate; receiving the plate from the exposing means on a receiving means, and thereafter transporting the plate to a developing means for developing the image on the plate.

15. A method as claimed in claim 14 wherein when the plate is supplied from the supplying means to the exposing means, another succeeding plate is immediately transported from the stock to the supplying means.
